# EUROPEAN PATENT APPLICATION

(11) **EP 0 853 338 A1**
(43) Date of publication of application: **15.07.1998**
(21) Application number: 98100291.8
(22) Date of filing: 09.01.1998
(51) Int. Cl.: H01L 21/762

(54) **Improvements in or relating to semiconductor devices**

(30) Priority: 09.01.1997 US 34694 P
(71) Applicant: Texas Instruments Incorporated, Dallas, Texas 75251 (US)
(72) Inventor: Yoneoka, Yoshinobu, Abiko-shi, Chiba-ken 270-11 (JP); Fukuhara, Hideyuki, Inashiki-gun, Ibaraki-ken 300-03 (JP)
(74) Representative: Schwepfinger, Karl-Heinz, Dipl.-Ing.

(57) **Abstract**

A method for forming a semiconductor device (10) includes the steps of forming a local oxidation of semiconductor (LOCOS) region (90) in the non-critical dimension region, and forming a trench isolation area (104) in the narrow isolation widths which have the critical areas for the punch-through tolerance. The trench isolation area (104) forming step further includes the steps of growing a field oxide layer (90) in the trench isolation region with a nitride/oxide hard mask (84), and applying a trench oxide/silicon etch to form poly sidewall spacers (94) which are formed at the mask edges. Filling said trench isolation areas with an oxide (104) occurs next, followed by forming a second LOCOS region (114) in non-isolation areas with CVD oxide. The result is a highly scalable and low leakage device isolation technology that effectively combines trench isolation with LOCOS isolation.

## Description

### TECHNICAL FIELD OF THE INVENTION

The present invention relates generally to semiconductor devices and, more particularly, to an isolation method to combine trench isolation with LOCOS isolation techniques and the resulting semiconductor devices.

### BACKGROUND OF THE INVENTION

In the fabrication of semiconductor electronic devices, there are two generally accepted methods for forming isolation regions: LOCOS isolation technology and trench isolation technology.

LOCOS isolation technology has been adopted widely in the fabrication of semiconductor integrated circuits. However, in the deep submicron regions of a semiconductor device, LOCOS isolation does not provide acceptable performance characteristics for many applications. In particular, LOCOS isolation does not provide acceptable punch-through tolerance. In addition, with LOCOS isolation techniques, field oxide thinning can occur in the narrow isolation widths of these devices. Furthermore, large pattern shifts by the lateral oxide encroachment can often occur in devices that use LOCOS isolation techniques.

Trench isolation technology provides acceptable punch-through tolerance. This technology, however, suffers from other limitations. For example, with trench isolation technology, double thresholds can occur, which are caused by the parasitic leakage along the trench sidewalls. In addition, trench isolation technology often fails to fill the various sized trenches with insulator materials. For these reasons, trench isolation is not acceptable for a wide variety of semiconductor devices.

### SUMMARY OF THE INVENTION

From the above-mentioned limitations, clearly there is a need for an isolation method that overcomes the problems of LOCOS isolation structures in submicron regions and that overcomes the parasitic leakage and incomplete trench fill limitations of trench isolation structures for semiconductor electronic devices.

The present invention, therefore, provides a method for forming an isolation region in a semiconductor electronic device that combines the advantages of a high degree of scalability in a LOCOS isolation and a low leakage current in a trench isolation formation. These advantages overcome or substantially eliminate the limitations of known methods of forming semiconductor device isolation regions.

According to one aspect of the present invention, there is provided a method for forming an isolation region of a semiconductor device that permits forming an isolation structure that works well in both non-critical dimensions and critical punch-through tolerance dimensions. The method includes the steps of forming a local oxidation of semiconductor (LOCOS) structure in the non-critical dimension region and a trench isolation structure in the narrow isolation widths which have the critical areas for the punch-through tolerance. The trench isolation structure forming step includes the steps of growing a field oxide layer with a nitride/oxide hard mask and applying a trench oxide/silicon etch to form polysilicon sidewall spacers which are formed at the mask edges. Filling region for the trench isolation structure with an oxide occurs next, followed by forming a second locos structure in non-isolation regions with CVD oxide. The result is a highly scalable and low leakage device isolation structure forming process that effectively combines a trench isolation structure with a LOCOS isolation structure.

A technical advantage that the present invention provides is an isolation structure formation process that compensates for disadvantages of both conventional LOCOS isolation structure forming process and conventional trench isolation structure forming process. with the present invention, trenches formed only in the narrow isolation areas facilitate trench filling. Because the first LOCOS isolation region keeps trench sidewalks away from active device areas, the double threshold problem does not occur.

Another technical advantage of the present invention is a process in which oxide thinning problems do not arise. This is because, as the mask windows for the first LOCOS isolation region are maintained at less than the critical dimension, the pattern shift by the lateral oxide encroachment is minimized by a thin field oxide.

### BRIEF DESCRIPTION OF THE DRAWINGS

The present invention will now be further described by way of example, with reference to the accompanying drawings in which:
Figures 1A and 1B show two examples of LOCOS isolation regions from according to conventional processes;
Figure 2 illustrates one embodiment of a trench isolation region form by a conventional trench isolation region forming process;
Figure 3 shows one embodiment of the trench LOCOS isolation region formed according to the teachings of the present invention;
Figures 4A through 4T demonstrate successive steps in trench LOCOS isolation region formation process of the present invention; and
Figures 5A through 5M demonstrate successive steps in the trench LOCOS isolation region formation process of the present invention.

### DETAILED DESCRIPTION OF THE INVENTION

Preferred embodiments of the present invention are illustrated in the Figures with like numerals being used to refer to like and corresponding parts of the various drawings.

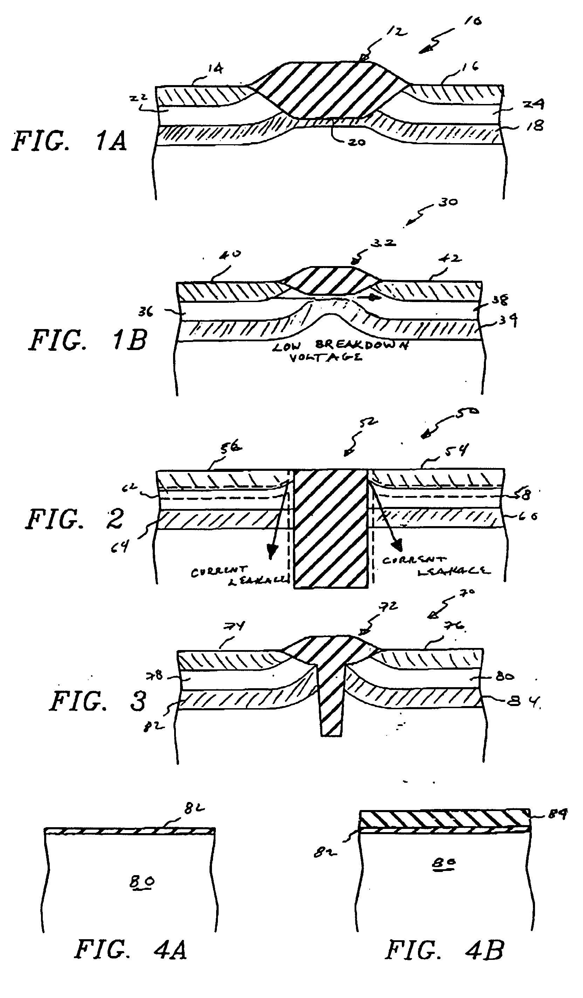

Figures 1A and 1B show semiconductor devices 10 that includes LOCOS isolation region 12, separates device region 14 from device region 16 of Figure 1A. LOCOS isolation region 12 provides electrical isolation between device region 14 and device region 16 by providing an electrical stop 20. This separates silicon region 22 from polysilicon region 24.

Figure 1B shows, however, semiconductor device 30, with a reduced size LOCOS region 32 for which channel stop doping layer 34 does not contact LOCOS region 32. Therefore, lower breakdown voltage can provide a current path between polysilicon region 36 and polysilicon region 38. This will adversely affect device regions 40 and 42. The low breakdown voltage that Figure 1B depicts illustrates that LOCOS isolation formation is not acceptable in the deep, sub-micron region because of poor punch-through arising in the thin field oxide layers.

Figure 2 shows semiconductor device 50 for which oxide fill trench 52 separates device region 54 from device region 56. In semiconductor device 50, polysilicon layer 58 covers channel stop doping layer 60 with polysilicon region 62 covering channel stop doping region 64. Although trench isolation region 52 provides satisfactory punch-through tolerance, the thresholds caused by parasitic leakage along the trench sidewalks arises. Moreover, it can be difficult to fill various sized trenches with the necessary oxide insulator materials.

To solve the above problems, the present invention provides for the formation of semiconductor device 70 that includes trench LOCOS isolation structure 72, to separate device region 74 from device region 76. Trench LOCOS isolation structure 72 also avoids the problem of punch-through between polysilicon region 78 and polysilicon region 80. In addition, current leakage does not arise with regard to channel stop doping layers 82 and 84.

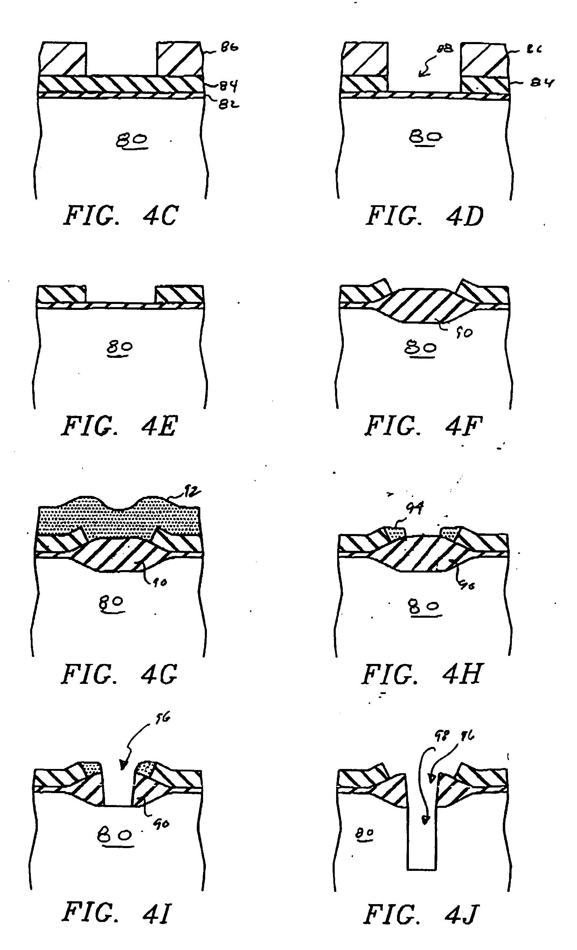

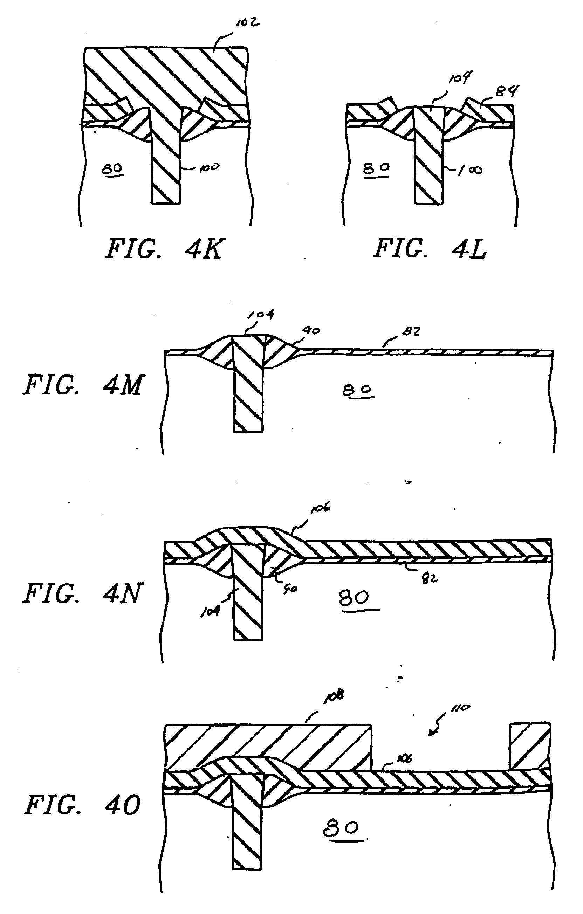

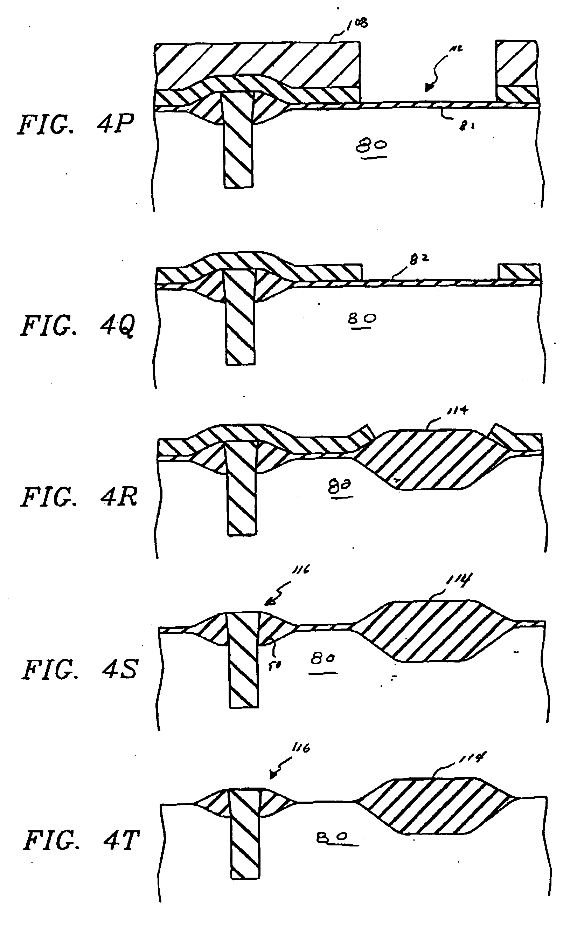

Figures 4A through 4T illustrate the process of forming trench LOCOS isolation region 70 according to the teachings of the present invention. Thus, Figure 4A illustrates first forming on semiconductor substrate 80 a pad oxidation deposition 82. In Figure 4B, nitride deposition occurs to produce nitride layer 84. Then, as Figure 4C shows, a photolithographic pattern 86 is formed on nitride layer 84, so that as Figure 4D illustrates, an etch of nitride layer 84 occurs to produce etched region 88. Then, as Figure 4E illustrates, mass 86 is removed.

In Figure 4F, a field oxidation step occurs to produce oxidized region 90. Then, a sidewall polysilicon layer 92 is formed, as Figure 4G shows. Then, a sidewall polysilicon etchback occurs, leaving only sidewall polysilicon region 94, as Figure 4H shows.

Figure 4I shows the result of etching LOCOS region 90 to form LOCOS trench 96. Then, as Figure 4J depicts, trench region 98 is formed beneath LOCOS etch region 96. Figure 4K shows the results of the step of filling trench region 100, which includes trench 98 and LOCOS etch region 96, where an oxide deposition layer 102. An oxide etchback step then occurs, as shown in Figure 4L, to remove all of oxide deposition layer 102, except for that portion 104 filling trench 100.

Figure 4M shows the results of the next step of etching nitride layer 84 to expose pad oxide deposition layer 82, LOCOS region 90, and oxide fill region 104. Then, nitride-2 layer 106 is deposited over pad oxide 82, LOCOS structure 90 and fill oxide 104, as Figure 4N depicts. A second node pattern 108 covers nitride-2 layer 106, except for exposed area 110, as Figure 40 shows. Figure 4P depicts the result of a nitride etch process to generate etch area 112, exposing pad oxide layer 82. Then, as Figure 4Q shows, etch pattern 108 is removed, to expose pad oxide 82. A field oxidation step may occur, as Figure 4R illustrates, to produce field oxidation area 114. Then, nitride-2 etch occurs, as Figure 4S shows, to expose trench LOCOS area 116, formed from fill oxide 104 and LOCOS region 90. Also exposed is LOCOS region 114. Finally, a moat etch occurs to separate by substrate 80 trench LOCOS region 116 from LOCOS region 114 to yield the Figure 4T structure.

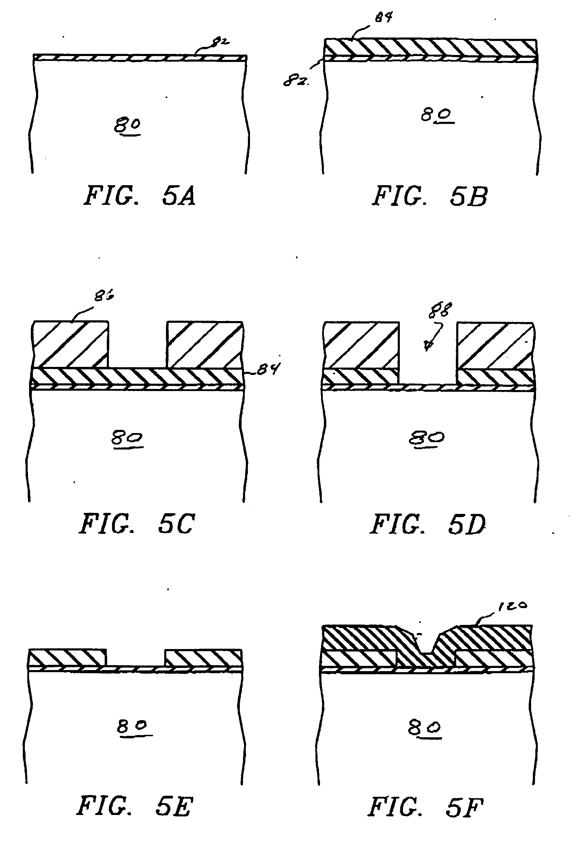

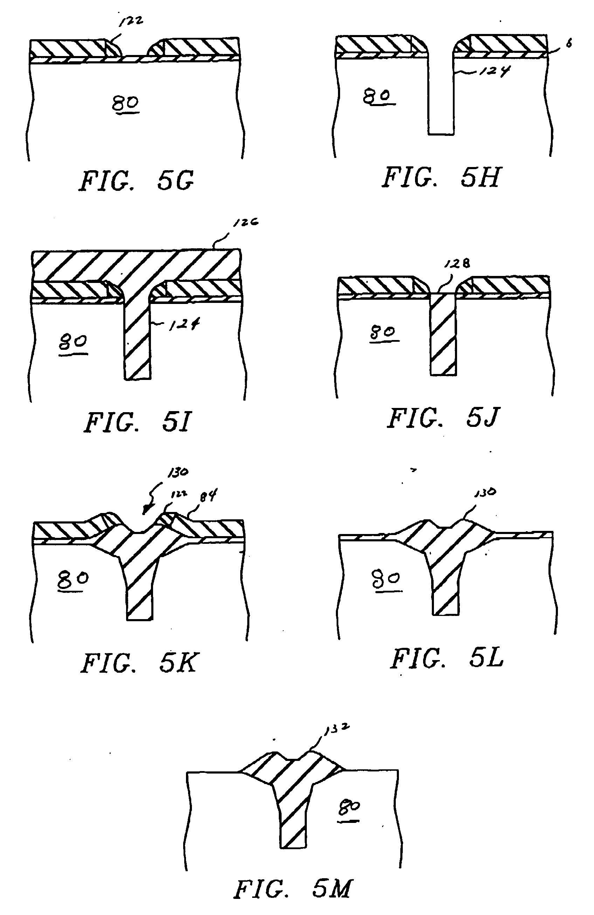

Figures 5A through 5M depict an alternative embodiment of the present invention to provide a trench LOCOS region. Figure 5A shows formation of pad oxide layer 82 on substrate 80. Then, in Figure 5B, nitride deposition layer 84 may be formed on pad oxide layer 82. Moat pattern mask 86 is deposited over nitride layer 84, as Figure 5C shows. Then, moat area 88 is formed by the removal of the portion of nitride layer 84 that moat pattern 86 exposes, as Figure 5D shows. In Figure 5E, the moat pattern mask is removed. Figure 5F shows the formation of a sidewall nitride deposition layer 120. In Figure 5G, sidewall nitride deposition layer 120 is etched back to form sidewall region 122, as Figure 5G shows. Figure 5H shows the next step of forming trench region 124 beneath pad oxide layer 82 and substrate 80. Then, as Figure 5I shows, filling oxide 126 is deposited to fill trench region 124. Figure 5J shows the step of etching back filling oxide layer 126 to form oxide region 128. Then, as Figure 5K shows, a field oxidation takes place to form trench LOCOS isolation area 130 beneath nitride layer 84, and sidewall 122. A nitride etch then occurs, as Figure 5L shows, to expose trench locos region 120. Thereafter, a nitride etch occurs to expose substrate 80 and provide the final trench LOCOS isolation area 132.

Although the invention has been described in detail herein with reference to the illustrative embodiments, it is to be understood that this description is by way of example only and is not to be construed in a limiting sense. It is to be further understood, therefore, that numerous changes in the details of the embodiments of the invention and additional embodiments of the invention, will be apparent to, and may be made by, persons of ordinary sill in the art having reference to this description. In fact, there may be other ways to form the structure of Figures 4A through 4T, and 5A through 5M that are clearly within the scope of the present invention.

## Claims

1. A method for forming in isolation structure for a semiconductor device having a non-critical and a critical punch-through dimension regions in a isolation, comprising the steps of:
forming a local oxidation of semiconductor (LOCOS) structure in the non-critical dimension region of the isolation region; and
forming a trench isolation structure in the critical dimension region of the single isolation region.

2. The method of Claim 1, wherein said trench isolation structure forming step comprises the steps of:
growing a field oxide layer in a trench isolation region with a nitride/oxide hard mask;
applying a trench oxide/silicon etch to form poly sidewall spacers at the mask edges;
filling said trench isolation structure with an oxide; and
forming a second locos in non-isolation areas.

3. The method of Claim 2, wherein said step of growing a field oxide comprises growing a CVD oxide.

4. The method of Claim 2 or Claim 3, wherein said trench oxide/silicon etch applying step comprises the step of applying said trench oxide/silicon etch as a nitride etch.

5. An isolation structure for a semiconductor device isolation region having both non-critical and critical punch-through dimension region, comprising:
a local oxidation of semiconductor (LOCOS) portion of said structure formed in the non-critical punch-through dimension region of said isolation region; and
a trench isolation region of said isolation structure formed in the critical punch-through dimension region.

6. The isolation structure of Claim 5, wherein said isolation structure is formed by performing the steps of:
a field oxide layer formed in the trench isolation region with a nitride/oxide hard mask;
poly sidewall spacers formed at the edges of said nitride/oxide hard mask; and said trench isolation region with an oxide.

7. The structure of Claim 6, wherein said oxide comprises a CVD oxide.
